# EUROPÄISCHE PATENTSCHRIFT

(11) **EP 4 246 149 B1**
(45) Veröffentlichungstag und Bekanntmachung des Hinweises auf die Patenterteilung: **02.07.2025**
(21) Anmeldenummer: 22163046.0
(22) Anmeldetag: 18.03.2022
(51) Int. Cl.: G01R 22/06

(54) **ELEKTRIZITÄTSZÄHLER MIT EINER ELEKTRONISCHEN STEUERUNG UND EINEM NETZTEIL**
ELECTRICITY METER WITH ELECTRONIC CONTROL AND POWER SUPPLY
COMPTEUR D'ÉLECTRICITÉ DOTÉ D'UNE COMMANDE ÉLECTRONIQUE ET D'UNE ALIMENTATION ÉLECTRIQUE

(43) Veröffentlichungstag der Anmeldung: 20.09.2023
(73) Patentinhaber: EMH metering GmbH & Co. KG, 19258 Gallin (DE)
(72) Erfinder: LÜBECK, Felix, 21075 Hamburg (DE); HARDTSTOCK, Heiko, 21337 Lüneburg (DE)
(74) Vertreter: Hauck Patent- und Rechtsanwälte PartmbB

(56) Entgegenhaltungen:
- EP-A1- 2 209 013
- DE-A1- 102020 122 869
- US-A1- 2016 084 885

## Beschreibung

Die Erfindung betrifft einen Elektrizitätszähler mit einer elektronischen Steuerung und einem Netzteil.

Über das Netzteil wird insbesondere der Eigenverbrauch des Elektrizitätszählers aus einem Versorgungsnetz, an das der Elektrizitätszähler angeschlossen ist, gedeckt. Dabei wird zwischen zwei Möglichkeiten unterschieden: Entweder ist das Netzteil "vor dem Elektrizitätszähler" an das Versorgungsnetz angeschlossen, so dass der Eigenverbrauch des Elektrizitätszählers von dem Elektrizitätszähler nicht erfasst wird. In diesem Fall wird der Elektrizitätszähler mit "ungezähltem Strom" betrieben. Oder das Netzteil ist "nach dem Elektrizitätszähler" an das Versorgungsnetz angeschlossen, so dass der Eigenverbrauch des Elektrizitätszählers von dem Elektrizitätszähler mit erfasst wird. In diesem Fall wird der Elektrizitätszähler mit "gezähltem Strom" betrieben.

Aus der Druckschrift EP 2 804 006 B1 ist ein Elektrizitätszähler bekannt geworden, der wahlweise mit gezähltem oder mit ungezähltem Strom betrieben werden kann. Um bei Inbetriebnahme des Elektrizitätszählers die gewünschte Alternative auszuwählen, wird ein spezieller Sicherungshalter in einer von zwei unterschiedlichen, möglichen Positionen eingesetzt.

Aus der Druckschrift EP 3 035 551 B1 ist ein Elektrizitätszähler bekannt geworden, der eine Vorrichtung zum Selbsttest seiner Messgenauigkeit aufweist, mit dem auch ein manipulationsbedingter Messfehler erkannt werden kann. Hierzu wird ein zusätzlicher Verbraucher mit einem bekannten, modulierten Stromverbrauch an den Stromkreis angeschlossen und es wird überprüft, ob der zusätzliche Verbrauch von dem Elektrizitätszähler korrekt erfasst wird.

Aus der Druckschrift EP 2 209 013 B1 ist ein Elektrizitätszähler bekannt geworden, das mit einem Drehstrom-Kondensatornetzteil eine elektronische Steuerung versorgen kann, die Messeinrichtungen auf den Außenleiterseiten (Phasen) und eine Steuereinrichtung auf der Neutralleiterseite umfasst.

Davon ausgehend ist es die Aufgabe der Erfindung, einen Elektrizitätszähler zur Verfügung zu stellen, mit dem eine Manipulation mit geringerem Aufwand aufgedeckt werden kann.

Diese Aufgabe wird gelöst durch den Elektrizitätszähler mit den Merkmalen des Anspruchs 1. Vorteilhafte Ausgestaltungen sind in den Unteransprüchen angegeben.

Der Elektrizitätszähler hat eine elektronische Steuerung, ein Netzteil und eine Schaltungsanordnung, die von der elektronischen Steuerung derart angesteuert wird, dass das Netzteil zeitweise mit gezähltem Strom und zeitweise mit ungezähltem Strom versorgt wird.

Der Elektrizitätszähler kann zum Beispiel ein Haushaltszähler oder ein Zähler für industrielle Anwendungen sein. Es kann sich um einen Wechselstromzähler oder einen Drehstromzähler handeln.

Die für den Betrieb der elektronischen Steuerung erforderliche Versorgungsspannung kann von dem Netzteil oder von einem weiteren Netzteil bereitgestellt werden. Das Netzteil kann einer Phase zugeordnet sein. Bei einem mehrphasigen Zähler können mehrere Netzteile, insbesondere ein Netzteil je Phase, vorhanden sein. Das Netzteil wandelt den Wechselstrom aus einem Versorgungsnetz in Gleichstrom um und stellt eine niedrige Spannung zum Beispiel im Bereich zwischen 2 Volt und 12 Volt zur Verfügung.

Die elektronische Steuerung steuert die Schaltungsanordnung an. Sie kann eine Messeinrichtung und/oder eine Auswerteeinrichtung und/oder eine Anzeige und/oder eine Kommunikationseinrichtung umfassen. Sie ist für den gesamten Eigenverbrauch des Elektrizitätszählers oder für einen Teil davon verantwortlich. Die genannten Elemente der elektronischen Steuerung sind insbesondere auf einer Leiterplatte und ganz oder teilweise in integrierter Bauweise verwirklicht, insbesondere in Form eines Messchips und gegebenenfalls weiterer, integrierter Schaltkreise mit der erforderlichen externen Beschaltung. Die elektronische Steuerung kann mit einem Messabgriff oder mehreren Messabgriffen jeder Phase verbunden sein und Spannung und Strom der Phase messen und aus den gemessenen Strom- und Spannungswerten Verbrauchswerte ermitteln. Die Elemente der elektronischen Steuerung, insbesondere eine Messeinrichtung und eine Steuereinrichtung, können zwischen Neutralleiterseite und Außenleiterseite (Phase) aufgeteilt sein.

Eine Besonderheit der Erfindung besteht in der Schaltungsanordnung, die von der elektronischen Steuerung derart angesteuert wird, dass das Netzteil zeitweise mit gezähltem Strom und zeitweise mit ungezähltem Strom versorgt wird. Hierzu weist die Schaltungsanordnung zwei Zustände auf. In einem ersten Schaltzustand wird das Netzteil mit gezähltem Strom versorgt. In einem zweiten Schaltzustand wird das Netzteil mit ungezähltem Strom versorgt. Die elektronische Steuerung steuert die Schaltungsanordnung an. Insbesondere ist die elektronische Steuerung dazu ausgebildet, die Schaltungsanordnung von dem ersten Schaltzustand in den zweiten Schaltzustand umzuschalten und umgekehrt. Dies geschieht hinreichend schnell, um eine kontinuierliche Versorgung des Netzteils sicherzustellen. Die Schaltungsanordnung kann grundsätzlich in beliebiger, elektronisch ansteuerbarer Form ausgeführt sein, beispielsweise in Form eines Relais. Bevorzugt weist die Schaltungsanordnung einen elektronischen Schalter, insbesondere einen Transistor auf, der zwischen den beiden Schaltzuständen umgeschaltet werden kann.

Für die Funktionsfähigkeit der elektronischen Steuerung spielt es keine Rolle, ob das Netzteil mit gezähltem oder ungezähltem Strom versorgt wird. Eine Erfassung des Stromverbrauchs ist in beiden Fällen möglich. Der für die Erfindung wichtige Unterschied besteht darin, dass die von dem Elektrizitätszähler erhobenen Verbrauchsdaten sich je nach Schaltzustand der Schaltungsanordnung um den Eigenverbrauch oder einen Teil des Eigenverbrauchs unterscheiden, weil dieser im ersten Schaltzustand mitgezählt und im zweiten Schaltzustand nicht mitgezählt wird. Dies gilt allerdings nur, wenn der Elektrizitätszähler den Verbrauch ordnungsgemäß erfasst. Liegt eine Manipulation vor, insbesondere wenn eine von dem Elektrizitätszähler überwachte Leitung überbrückt wurde, kann der Elektrizitätszähler weder den Verbrauch der an das Versorgungsnetz angeschlossenen Verbraucher noch seinen Eigenverbrauch oder einen Teil seines Eigenverbrauchs ordnungsgemäß erfassen. Dies kann mithilfe der Schaltungsanordnung einfach festgestellt werden, indem die Schaltungsanordnung von der elektronischen Steuerung so angesteuert wird, dass der Elektrizitätszähler seinen Eigenverbrauch bzw. den betreffenden Anteil davon, der von dem Netzteil zur Verfügung gestellt wird, zeitweise erfasst und zeitweise nicht erfasst. Anschließend kann überprüft werden, ob die erfassten Verbräuche sich um den (bekannten) Eigenverbrauch bzw. den betreffenden Anteil des Eigenverbrauchs des Elektrizitätszählers unterscheiden.

Im Vergleich zu der aus der Druckschrift EP 3 035 551 B1 bekannten Lösung kann eine Manipulation mit besonders einfachen Mitteln aufgedeckt werden, weil kein zusätzlicher, modulierbarer Verbraucher benötigt wird. Die Schaltungsanordnung kann mit wenigen, sehr preiswerten Bauteilen realisiert werden.

Der Eigenverbrauch des Elektrizitätszählers bzw. der über das Netzteil bereitgestellte Teil davon ist zudem bauartbedingt und bekannt. Anders als bei einem zusätzlichen/externen Verbraucher ist es daher zum Erkennen einer Manipulation in der Regel nicht erforderlich, dem Elektrizitätszähler eine Information über den zu erwartenden, zusätzlichen Verbrauch verfügbar zu machen. Durch die von der elektronischen Steuerung des Elektrizitätszählers ausgeführte Ansteuerung der Schaltungsanordnung ist auch der jeweilige Schaltzustand für die Auswertung unmittelbar verfügbar.

Schließlich besteht ein Vorteil darin, dass der mit einem zusätzlichen Verbraucher einhergehende, zusätzliche Verbrauch nicht anfällt. Der Leistungsbedarf der Schaltungsanordnung ist praktisch zu vernachlässigen, es wird daher zu keinem Zeitpunkt spürbar mehr Leistung abgerufen als von einem herkömmlichen Elektrizitätszähler, weder in Form von Blindleistung noch in Form von Wirkleistung.

In einer Ausgestaltung ist das Netzteil zur Versorgung der elektronischen Steuerung vorgesehen. Zum Beispiel kann der Elektrizitätszähler genau ein (gegebenenfalls mehrphasiges) Netzteil aufweisen, das zur Versorgung sämtlicher Elemente der elektronischen Steuerung zuständig ist und/oder dass den gesamten Eigenverbrauch des Elektrizitätszählers zur Verfügung stellt.

In einer Ausgestaltung ist das Netzteil zur Versorgung eines Zusatzgeräts vorgesehen. Bei dem Zusatzgerät kann es sich z.B. um ein Smart Meter Gateway oder ein sonstiges elektronisches Gerät handeln, das über eine Schnittstelle Daten mit dem Elektrizitätszähler austauscht. Das Zusatzgerät kann in den Elektrizitätszähler integriert sein. Alternativ kann das Zusatzgerät in einem separaten Gehäuse angeordnet und mit dem Elektrizitätszähler verbunden sein, beispielsweise über eine Steckverbindung.

In einer Ausgestaltung weist der Elektrizitätszähler einen ersten Anschluss zum Anschließen an eine Phase eines Versorgungsnetzes, einen zweiten Anschluss zum Anschließen an ein Haushaltsnetz und einen zwischen die beiden Anschlüsse geschalteten Shunt auf, wobei die Schaltungsanordnung zur Versorgung des Netzteils mit gezähltem Strom in einem ersten Schaltzustand eine Verbindung zwischen dem Netzteil und dem zweiten Anschluss herstellt. Dass eine Verbindung zwischen dem Netzteil und dem zweiten Anschluss hergestellt wird bedeutet, dass einem Bauteil des Netzteils über diese Verbindung Energie zugeführt werden kann. Die im ersten Schaltzustand hergestellte Verbindung zwischen dem Netzteil und dem zweiten Anschluss besteht in einem zweiten Schaltzustand der Schaltungsanordnung nicht. Im zweiten Schaltzustand kann das Netzteil insbesondere mit dem ersten Anschluss verbunden sein, wobei diese Verbindung im ersten Schaltzustand nicht notwendigerweise getrennt werden muss. Es findet im ersten Schaltzustand jedoch keine oder keine wesentliche Energiezufuhr über die Verbindung zwischen dem ersten Anschluss und dem Netzteil statt.

In einer Ausgestaltung ist das Netzteil ein Kondensatornetzteil. Grundsätzlich kann das Netzteil eine beliebige Bauart haben, z.B. ein Schaltnetzteil sein oder einen Transformator aufweisen. Ein Kondensatornetzteil ist besonders einfach aufgebaut und kann wegen der Möglichkeit, den Kondensator des Netzteils über unterschiedliche Strompfade aufzuladen, mit einer besonders einfachen Schaltungsanordnung kombiniert werden. Insbesondere kann das Kondensatornetzteil einen Kondensator aufweisen, dessen Blindwiderstand als Vorwiderstand genutzt wird. In diesem Fall oder auch in Verbindung mit einem anderen Netzteiltyp kann das Netzteil einen Glättungskondensator und/oder eine Spannungsstabilisierungsschaltung aufweisen.

In einer Ausgestaltung weist das Kondensatornetzteil mindestens eine Zenerdiode und einen Kondensator auf, die in Reihe geschaltet sind, wobei die Schaltungsanordnung in dem ersten Schaltzustand einen Knotenpunkt zwischen dem Kondensator und der mindestens einen Zenerdiode mit dem zweiten Anschluss verbindet. Dadurch kann der Kondensator über den zweiten Anschluss, d.h. mit gezähltem Strom, aufgeladen werden. Insbesondere kann der nicht mit dem Knotenpunkt verbundene Anschluss des Kondensators direkt oder indirekt (z.B. über eine mit dem Nullleiter verbundene Mess- und Steuereinrichtung) an einen Nullleiter angeschlossen sein. Der nicht mit dem Knotenpunkt verbundene Anschluss der mindestens einen Zenerdiode kann mit dem ersten Anschluss verbunden sein. Dann wird während einer positiven Halbwelle (Potential der Phase am Versorgungsanschluss ist höher als Potential des Nullleiters) der Versorgungsspannung der Kondensator im ersten Schaltzustand über die von der Schaltungsanordnung hergestellte Verbindung mit gezähltem Strom aufgeladen. Im zweiten Schaltzustand wird der Kondensator während einer positiven Halbwelle über die mindestens eine (in Durchlassrichtung betriebene) Zenerdiode mit ungezähltem Strom aufgeladen.

In einer Ausgestaltung ist die Schaltungsanordnung so ausgeführt, dass ein Spannungsabfall, der im ersten Schaltzustand bei Stromfluss durch die hergestellte Verbindung auftritt, kleiner ist als ein Spannungsabfall an der mindestens einen Zenerdiode bei Betrieb der mindestens einen Zenerdiode in Durchlassrichtung. Dadurch wird erreicht, dass die Versorgung des Netzteilkondensators, der direkt oder indirekt mit dem Nullleiter verbundenen ist, bei der positiven Halbwelle praktisch vollständig mit gezähltem Strom erfolgt, wenn sich die Schaltungsanordnung im ersten Schaltzustand befindet. Dies gelingt bei entsprechend niedrigem Spannungsabfall an der Schaltungsanordnung bei Verwendung einer einzigen Zenerdiode. Alternativ können mehrere, insbesondere zwei oder drei Zenerdioden in Reihe geschaltet werden, wodurch sich der Spannungsabfall an den Zenerdioden entsprechend erhöht, z.B. auf das Doppelte oder Dreifache. Dadurch kann ein größerer Spannungsabfall an der Schaltungsanordnung in Kauf genommen und die Schaltungsanordnung gegebenenfalls mit geringerem Kostenaufwand realisiert werden.

In einer Ausgestaltung stellt die Schaltungsanordnung die Verbindung über einen Transistor und eine Schottky-Diode herstellt. Schottky-Dioden weisen einen besonders geringen Spannungsabfall auf, so dass der Spannungsabfall an der Kombination aus Transistor und Schottky-Diode klein gehalten werden kann, insbesondere kleiner als der Spannungsabfall an der mindestens einen Zenerdiode. Bei dem Transistor kann es sich insbesondere um einen Kleinsignaltransistor handeln.

In einer Ausgestaltung ist der Transistor ein Feldeffekt-Transistor. Diese Variante überzeugt durch einen geringen Spannungsabfall am durchgeschalteten Transistor sowie durch die besonders einfache, praktisch leistungslose Ansteuerung.

In einer Ausgestaltung ist die elektronische Steuerung dazu ausgebildet, die Schaltungsanordnung intervallweise und/oder in einem vorgegebenen zeitlichen Muster anzusteuern. Ein mehrfacher/regelmäßiger Wechsel zwischen den beiden Schaltzuständen vereinfacht die Auswertung der erfassten Verbräuche. In einer für Haushaltsanwendungen typischen Konfiguration, in der der Elektrizitätszähler in der Regel mit ungezähltem Strom versorgt werden soll, können die Intervalle, in denen das Netzteil mit gezähltem Strom versorgt wird, sehr kurz gehalten werden. Beispielsweise kann die Schaltungsanordnung so angesteuert werden, dass die Versorgung in 24 Stunden nur für mehrere kurze Intervalle von beispielsweise 10 s mit gezähltem Strom erfolgt, z.B. einmal in 15 Minuten. Der dem Haushalt dadurch zugeordnete Eigenverbrauch spielt dann für die Abrechnung keine Rolle und ist wesentlich kleiner als die zulässigen Messfehler.

Beispielsweise kann auch der zeitweise zugeordnete bekannte Eigenverbrauch von der Software aus dem Messergebnis herausgerechnet werden, damit erst gar kein Messfehler entstehen kann.

In einer Ausgestaltung weist die Schaltungsanordnung einen Steuereingang auf, der mit einem Ausgang der elektronischen Steuerung insbesondere auf der Außenleiterseite (Phase) verbunden ist. Hierzu kann die elektronische Steuerung insbesondere einen programmierbaren Ausgang aufweisen, so dass das gewünschte Umschalten der Schaltungsanordnung per Software gesteuert werden kann.

In einer Ausgestaltung weist die elektronische Steuerung einen Messchip mit einem Interrupt-Anschluss auf, der mit dem Steuereingang verbunden ist. Die den Elektrizitätszähler und/oder den Messchip steuernde Software kann dann so programmiert werden, dass an dem Interrupt-Anschluss eine für die Ansteuerung der Schaltungsanordnung erforderliche Spannung ausgegeben wird. Beispielsweise kann gezielt ein Fehler ausgelöst werden und die dadurch ausgelöste Fehlermeldung kann z.B. zu einem High-Signal an dem Interrupt-Anschluss führen. Auf diese Weise kann die Interrupt-Funktionalität eines Messchips, der keinen programmierbaren Ausgang aufweist, für die Ansteuerung der Schaltungsanordnung zweckentfremdet werden.

In einer Ausgestaltung weist der Elektrizitätszähler eine Auswerteeinrichtung auf, die dazu ausgebildet ist, einen Unterschied zwischen einem ersten Verbrauch in einem ersten Zeitraum, in dem das Netzteil mit ungezähltem Strom versorgt wurde, und einem zweiten Verbrauch in einem zweiten Zeitraum, in dem das Netzteil mit gezähltem Strom versorgt wurde, zu ermitteln und mit einem erwarteten Eigenverbrauch des Elektrizitätszählers zu vergleichen. Zeigt der Vergleich eine Abweichung, kann dies auf eine Manipulation hinweisen, insbesondere auf eine Strombrücke.

In einer Ausgestaltung weist der Elektrizitätszähler eine Kommunikationseinrichtung auf, die dazu ausgebildet ist, eine Manipulationswarnung zu versenden, wenn die Auswerteeinrichtung beim Vergleichen des ermittelten Unterschieds mit dem erwarteten Eigenverbrauch eine Abweichung feststellt. Auf diese Weise kann insbesondere ein Messstellenbetreiber automatisch auf eine möglicherweise vorliegende Manipulation hingewiesen werden.

Nachfolgend wird die Erfindung anhand von in Figuren dargestellten Ausführungsbeispielen näher erläutert. Es zeigen:
- Fig. 1: einen teils schematisch vereinfachten Schaltplan eines Wechselstromzählers, und
- Fig. 2: einen teils schematisch vereinfachten Schaltplan eines Drehstromzählers.

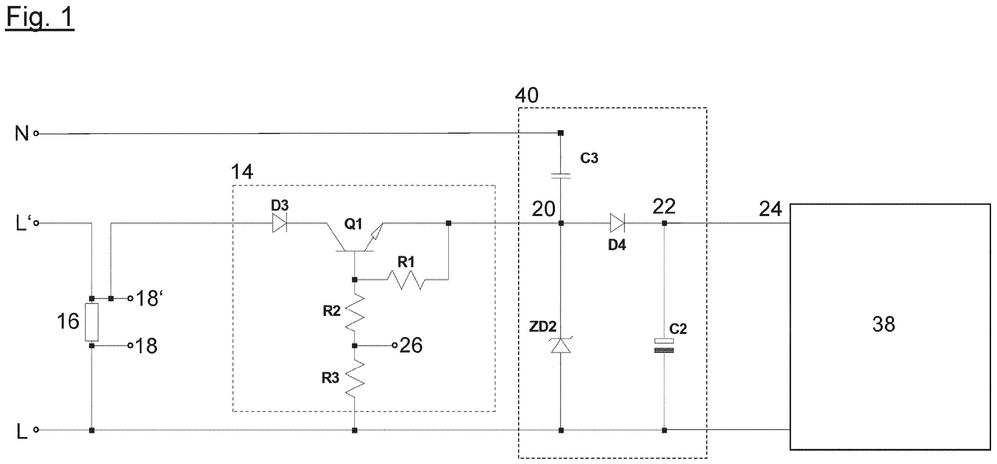

Der Elektrizitätszähler aus Fig. 1 hat eine elektronische Steuerung 38, ein Netzteil 40 zur Versorgung der elektronischen Steuerung 38 und eine Schaltungsanordnung 14. Bei dem Elektrizitätszähler handelt es sich um einen Wechselstromzähler zur Erfassung des Verbrauchs von nur einer Phase. Ein erster Anschluss L ist an eine Phase eines Versorgungsnetzes angeschlossen, ein zweiter Anschluss L' an die entsprechende Phase eines Haushaltsnetzes. Ein weiterer Anschluss N des Elektrizitätszählers ist direkt oder indirekt an einen Nullleiter angeschlossen. Zwischen dem ersten Anschluss L und dem zweiten Anschluss L' ist ein Shunt 16 geschaltet. An den beiden Enden des Shunts 16 ist jeweils ein Messabgriff 18, 18' ausgebildet und mit einem entsprechenden Eingang des Elektrizitätszählers verbunden, was in der Figur nicht dargestellt ist. Der Elektrizitätszähler erfasst an den Messabgriffen 18, 18' einen Spannungsabfall an dem Shunt 16, um den Stromfluss zu ermitteln, und zusätzlich die Spannung an der Phase. Auf dieser Grundlage kann der Verbrauch des Haushalts in an sich bekannter Weise von dem Elektrizitätszähler gemessen werden.

Das Netzteil 40 ist ein Kondensatornetzteil mit einem Kondensator C3, bei dem es sich um einen X2-Kondensator handelt, und einer Zenerdiode ZD2. Ein Anschluss des Kondensators C3 und die Kathode der Zenerdiode ZD2 sind mit dem Knotenpunkt 20 verbunden. Die Anode der Zenerdiode ZD2 ist mit dem ersten Anschluss L verbunden. Der nicht mit dem Knotenpunkt 20 verbundene Anschluss des Kondensators C3 ist mit dem weiteren Anschluss N, d.h. direkt oder indirekt mit dem Nullleiter verbunden. Ebenfalls mit dem Knotenpunkt 20 verbunden ist die Anode einer Diode D4. Die Kathode dieser Diode D4 ist mit einem Glättungskondensator C2 verbunden, dessen anderer Anschluss mit dem zweiten Anschluss L verbunden ist.

Der Knotenpunkt 22 zwischen der Kathode der Diode D4 und dem Glättungskondensator C2 bildet einen Ausgang des Kondensatornetzteils, der mit einem Versorgungsanschluss 24 der elektronischen Steuerung 38 verbunden ist.

Die Schaltungsanordnung 14 umfasst eine Diode D3 und einen Transistor Q1, über die in einem ersten Schaltzustand, in dem der Transistor Q1 durchgeschaltet ist, eine Verbindung zwischen dem zweiten Anschluss L' und dem Kontenpunkt 20 des Netzteils 40 besteht. In einem zweiten Schaltzustand ist der Transistor Q1 gesperrt und die Verbindung besteht nicht. Die Schaltungsanordnung weist außerdem eine Steuereingang 26 und drei Widerstände R1, R2 und R3 auf. Der Steuereingang 26 ist auf nicht dargestellte Weise mit der elektronischen Steuerung 38 verbunden, so dass die Schaltungsanordnung 14 von der elektronischen Steuerung 38 gezielt in den ersten Schaltzustand und in den zweiten Schaltzustand versetzt werden kann.

Bei der Diode D3 handelt es sich um eine Schottky-Diode. Der Transistor Q1 ist ein Bipolartransistor, es kann jedoch an dieser Stelle alternativ auch ein Feldeffekt-transistor eingesetzt werden.

Die Schaltungsanordnung 14 arbeitet wie folgt:
Liegt am Steuereingang 26 eine Spannung an, die niedriger ist als die Spannung am Knotenpunkt 20, ist der Transistor Q1 gesperrt und die Schaltungsanordnung 14 befindet sich im zweiten Schaltzustand. Während einer positiven Halbwelle am ersten Anschluss L ist das Potential dort höher als Nullleiter-Potential an dem weiteren Anschluss N. Der Kondensator C3 wird über die Zenerdiode ZD2 aufgeladen.

Liegt am Steuereingang 26 eine Spannung an, die höher ist als die Spannung am Knotenpunkt 20, ist der Transistor Q1 durchgeschaltet und die Schaltungsanordnung 14 befindet sich im ersten Schaltzustand. Während der positiven Halbwelle ist das Potential am zweiten Anschluss L' fast gleich groß wie das Potential am ersten Anschluss L, weil der Spannungsabfall an dem Shunt 16 sehr gering ist, und darum ebenfalls größer als das Nullleiter-Potential. Der Spannungsabfall an der Diode D3 und an dem Transistor Q1 ist kleiner als der Spannungsabfall an der in Durchlassrichtung betriebenen Zenerdiode ZD2, so dass der Kondensator C3 jetzt über die von der Schaltungsanordnung 14 hergestellte Verbindung mit gezähltem Strom von dem zweiten Anschluss L' aufgeladen wird.

Während einer negativen Halbwelle ist das Potential an dem ersten Anschluss L niedriger als das Nullleiter-Potential an dem weiteren Anschluss N. Unabhängig vom Schaltzustand der Schaltungsanordnung 14 entlädt sich der Kondensator C3 über die in Sperrrichtung betriebene Zenerdiode ZD2, wodurch der Kondensator C2 über die Diode D4 aufgeladen und am Knotenpunkt 22 eine Versorgungsspannung für die elektronische Schaltung 38 bereitgestellt wird.

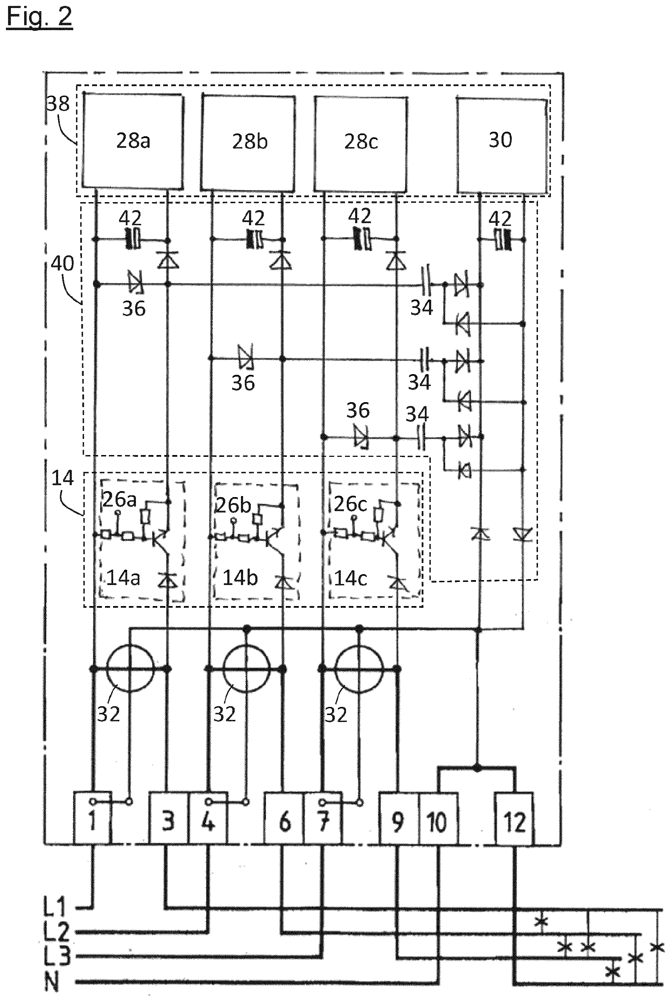

Der Elektrizitätszähler aus Fig. 2 ist ein Drehstromzähler mit drei ersten Anschlüssen 1, 4 und 7, die jeweils an eine Phase L1, L2 bzw. L3 eines Versorgungsnetzes angeschlossen sind, und drei zweiten Anschlüssen 3, 6 und 9, die mit der entsprechenden Phase eines Haushaltsnetzes verbunden sind. Ein weiterer Anschluss 10 des Elektrizitätszählers ist an den Nullleiter N des Versorgungsnetzes angeschlossen, noch ein weiterer Anschluss 12 an den Nullleiter des Haushaltsnetzes. Zwischen den ersten Anschlüssen 1, 4 und 7 und den zweiten Anschlüssen 3, 6 und 9 ist jeweils ein schematisch dargestelltes Messwerk 32 geschaltet.

Die elektronische Steuerung 38 ist in diesem Ausführungsbeispiel detaillierter dargestellt, als im Ausführungsbeispiel der Fig. 1. Sie umfasst drei jeweils einer Phase zugeordnete, elektronische Messeinrichtungen 28a, 28b, 28c, die auf der Außenleiterseite (Phase) angeordnet sind, sowie eine elektronische Steuereinrichtung 30, die auf der Nulleiterseite angeordnet ist.

Das Netzteil 40 umfasst drei Untereinheiten aus jeweils einem Kondensator 34 und einer Zenerdiode 36. Diese Untereinheiten sind jeweils einer der drei Phasen L1, L2, L3 zugeordnet. Ebenfalls zu dem Netzteil 40 zählen die übrigen, innerhalb des mit dem Bezugszeichen 40 versehenen Kastens angeordneten Dioden und die vier Glättungskondensatoren 42.

Die Schaltungsanordnung 14 umfasst drei Schaltungsanordnungen 14a, 14b, 14c, die jeweils einer Phase zugeordnet sind und jeweils einen Steuereingang 26 aufweisen. Die Funktion sowie der Aufbau der Schaltungsanordnungen 14a, 14b und 14c entsprechen der Schaltungsanordnung 14 aus dem Ausführungsbeispiel der Fig. 1.

Für die in der Fig. 2 nicht im Einzelnen dargestellte Ansteuerung der Schaltungsanordnung durch die elektronische Steuerung 38 gibt es unterschiedliche Möglichkeiten. Beispielsweise kann die Steuereinrichtung 30 diese Ansteuerung übernehmen. In diesem Fall kann zur Überbrückung der Potentialdifferenz zwischen der Nulleiterseite und der Außenleiterseite ein potentialüberbrückender Signalgeber wie z.B. ein Optokoppler eingesetzt werden.

Alternativ können die Messeinrichtungen 28a, 28b und 28c die zu der Schaltungsanordnung 14a, 14b bzw. 14c der jeweiligen Phase gehörenden Steuereingänge 26a, 26b, 26c ansteuern, wobei auf einen potentialüberbrückenden Signalgeber verzichtet werden kann. Insbesondere kann die Ansteuerung unmittelbar über einen Steuerausgang oder einen Interrupt-Anschluss der jeweiligen Messeinrichtung 28a, 28b, 28c erfolgen.

### Liste der Bezugszeichen

- 1: erster Anschluss
- 3: zweiter Anschluss
- 4: erster Anschluss
- 6: zweiter Anschluss
- 7: erster Anschluss
- 9: zweiter Anschluss
- 10: weiterer Anschluss
- 12: weiterer Anschluss
- 14, 14a, 14b, 14c: Schaltungsanordnung
- 16: Shunt
- 18: Messabgriff
- 18': Messabgriff
- 20: Knotenpunkt
- 22: Knotenpunkt
- 24: Versorgungsanschluss
- 26, 26a, 26b, 26c: Steuereingang
- 28a, 28b, 28c: elektronische Messeinrichtung
- 30: elektronische Steuereinrichtung
- 32: Messwerk
- 34: Kondensator
- 36: Zenerdiode
- 38: elektronische Steuerung
- 40: Netzteil
- 42: Glättungskondensator
- L: erster Anschluss (Phase Versorgungsnetz)
- L': zweiter Anschluss (Phase Haushaltsnetz)
- N: weiterer Anschluss (Nullleiter)

## Patentansprüche

1. Elektrizitätszähler mit einer elektronischen Steuerung (38) und einem Netzteil (40), **gekennzeichnet durch** eine Schaltungsanordnung (14), die von der elektronischen Steuerung (38) derart angesteuert wird, dass das Netzteil (40) zeitweise mit gezähltem Strom und zeitweise mit ungezähltem Strom versorgt wird.

2. Elektrizitätszähler nach Anspruch 1, **dadurch gekennzeichnet, dass** das Netzteil (40) zur Versorgung der elektronischen Steuerung (38) vorgesehen ist.

3. Elektrizitätszähler nach Anspruch 1 oder 2, **dadurch gekennzeichnet, dass** das Netzteil (40) zur Versorgung eines Zusatzgeräts vorgesehen ist.

4. Elektrizitätszähler nach einem der Ansprüche 1 bis 3, **dadurch gekennzeichnet, dass** der Elektrizitätszähler einen ersten Anschluss (L) zum Anschließen an eine Phase eines Versorgungsnetzes, einen zweiten Anschluss (L') zum Anschließen an ein Haushaltsnetz und einen zwischen die beiden Anschlüsse geschalteten Shunt (16) aufweist, wobei die Schaltungsanordnung (14) zur Versorgung des Netzteils (40) mit gezähltem Strom in einem ersten Schaltzustand eine Verbindung zwischen dem Netzteil (40) und dem zweiten Anschluss (L') herstellt.

5. Elektrizitätszähler nach einem der Ansprüche 1 bis 4, **dadurch gekennzeichnet, dass** das Netzteil (40) ein Kondensatornetzteil ist.

6. Elektrizitätszähler nach Anspruch 5, **dadurch gekennzeichnet, dass** das Kondensatornetzteil einen Kondensator (C3) und mindestens eine Zenerdiode (ZD2) aufweist, die in Reihe geschaltet sind, wobei die Schaltungsanordnung (14) in dem ersten Schaltzustand einen Knotenpunkt (20) zwischen dem Kondensator (C3) und der mindestens einen Zenerdiode (ZD2) mit dem zweiten Anschluss (L') verbindet.

7. Elektrizitätszähler nach Anspruch 6, **dadurch gekennzeichnet, dass** die Schaltungsanordnung (14) so ausgeführt ist, dass ein Spannungsabfall, der im ersten Schaltzustand bei Stromfluss durch die hergestellte Verbindung auftritt, kleiner ist als ein Spannungsabfall an der mindestens einen Zenerdiode (ZD2) bei Betrieb in Durchlassrichtung.

8. Elektrizitätszähler nach einem der Ansprüche 1 bis 7, **dadurch gekennzeichnet, dass** die Schaltungsanordnung (14) die Verbindung über einen Transistor (Q1) und eine Schottky-Diode (D3) herstellt.

9. Elektrizitätszähler nach Anspruch 8, **dadurch gekennzeichnet, dass** der Transistor (Q1) ein Feldeffekt-Transistor ist.

10. Elektrizitätszähler nach einem der Ansprüche 1 bis 9, **dadurch gekennzeichnet, dass** die elektronische Steuerung (38) dazu ausgebildet ist, die Schaltungsanordnung (14) intervallweise und/oder in einem vorgegebenen zeitlichen Muster anzusteuern.

11. Elektrizitätszähler nach einem der Ansprüche 1 bis 10, **dadurch gekennzeichnet, dass** die Schaltungsanordnung (14) einen Steuereingang (26) aufweist, der mit einem Ausgang der elektronischen Steuerung (38) verbunden ist.

12. Elektrizitätszähler nach Anspruch 11, **dadurch gekennzeichnet, dass** die elektronische Steuerung (38) einen Messchip mit einem Interrupt-Anschluss aufweist, der mit dem Steuereingang (26) verbunden ist.

13. Elektrizitätszähler nach einem der Ansprüche 1 bis 12, **dadurch gekennzeichnet, dass** der Elektrizitätszähler eine Auswerteeinrichtung aufweist, die dazu ausgebildet ist, einen Unterschied zwischen einem ersten Verbrauch in einem ersten Zeitraum, in dem das Netzteil (40) mit ungezähltem Strom versorgt wurde, und einem zweiten Verbrauch in einem zweiten Zeitraum, in dem das Netzteil (40) mit gezähltem Strom versorgt wurde, zu ermitteln und mit einem erwarteten Eigenverbrauch des Elektrizitätszählers zu vergleichen.

14. Elektrizitätszähler nach einem der Ansprüche 1 bis 13, **dadurch gekennzeichnet, dass** der Elektrizitätszähler eine Kommunikationseinrichtung aufweist, die dazu ausgebildet ist, eine Manipulationswarnung zu versenden, wenn die Auswerteeinrichtung beim Vergleichen des ermittelten Unterschieds mit dem erwarteten Eigenverbrauch eine Abweichung feststellt.

## Claims

1. An electricity meter with an electronic controller (38) and a power supply (40), **characterized by** a circuit arrangement (14) that is actuated by the electronic controller (38) in such a way that the power supply (40) is sometimes supplied with metered energy and sometimes with unmetered energy.

2. The electricity meter according to claim 1, **characterized in that** the power supply (40) is provided for supplying the electronic controller (38).

3. The electricity meter according to claim 1 or 2, **characterized in that** the power supply (40) is provided for supplying an additional device.

4. The electricity meter according to any one of claims 1 to 3, **characterized in that** the electricity meter has a first terminal (L) for connection to a phase of a supply network, a second terminal (L') for connection to a household network, and a shunt (16) connected between the two terminals, wherein the circuit arrangement (14) establishes a connection between the power supply (40) and the second terminal (L') in order to supply the power supply (40) with metered energy in a first switching state.

5. The electricity meter according to any one of claims 1 to 4, **characterized in that** the power supply (40) is a capacitor power supply.

6. The electricity meter according to claim 5, **characterized in that** the capacitor power supply has a capacitor (C3) and at least one Zener diode (ZD2), which are connected in series, wherein the circuit arrangement (14), in the first switching state, connects a node (20) between the capacitor (C3) and the at least one Zener diode (ZD2) to the second terminal (L').

7. The electricity meter according to claim 6, **characterized in that** the circuit arrangement (14) is designed such that a voltage drop that occurs in the first switching state when current flows through the established connection is less than a voltage drop across the at least one Zener diode (ZD2) when same is operated in the forward direction.

8. The electricity meter according to any one of claims 1 to 7, **characterized in that** the circuit arrangement (14) establishes the connection via a transistor (Q1) and a Schottky diode (D3).

9. The electricity meter according to claim 8, **characterized in that** the transistor (Q1) is a field-effect transistor.

10. The electricity meter according to any one of claims 1 to 9, **characterized in that** the electronic controller (38) is designed to actuate the circuit arrangement (14) in intervals and/or in a predefined time pattern.

11. The electricity meter according to any one of claims 1 to 10, **characterized in that** the circuit arrangement (14) has a control input (26) which is connected to an output of the electronic controller (38).

12. The electricity meter according to claim 11, **characterized in that** the electronic controller (38) has a measuring chip with an interrupt terminal which is connected to the control input (26).

13. The electricity meter according to any one of claims 1 to 12, **characterized in that** the electricity meter has an evaluation apparatus which is designed to determine a difference between a first consumption in a first period of time, in which the power supply (40) was supplied with unmetered energy, and a second consumption in a second period of time, in which the power supply (40) was supplied with metered energy, and to compare said difference with the electricity meter's expected own consumption.

14. The electricity meter according to any one of claims 1 to 13, **characterized in that** the electricity meter has a communication apparatus which is designed to send a manipulation warning if the evaluation apparatus identifies a deviation upon comparing the determined difference with the expected own consumption.

## Revendications

1. Compteur d'électricité doté d'une commande électronique (38) et d'une alimentation électrique (40), **caractérisé par** un circuit (14), lequel est actionné de telle façon par la commande électronique (38), que l'alimentation électrique (40) est approvisionnée par moments en courant compté et par moments en courant non compté.

2. Compteur d'électricité selon la revendication 1, **caractérisé en ce que** l'alimentation électrique (40) est prévue pour l'approvisionnement de la commande électronique (38).

3. Compteur d'électricité selon la revendication 1 ou 2, **caractérisé en ce que** l'alimentation électrique (40) est prévue pour l'approvisionnement d'un appareil auxiliaire.

4. Compteur d'électricité selon l'une des revendications 1 à 3, **caractérisé en ce que** le compteur d'électricité présente une première borne (L) pour la connexion à une phase d'un réseau de distribution, une deuxième borne (L') pour la connexion à un réseau domestique et un shunt (16) placé entre les deux bornes, dans lequel le circuit (14) établit une liaison entre l'alimentation électrique (40) et la deuxième borne (L') pour l'approvisionnement de l'alimentation électrique (40) en courant compté dans un premier état de commutation.

5. Compteur d'électricité selon l'une des revendications 1 à 4, **caractérisé en ce que** l'alimentation électrique (40) est une alimentation électrique à condensateur.

6. Compteur d'électricité selon la revendication 5, **caractérisé en ce que** l'alimentation électrique à condensateur présente un condensateur (C3) et au moins une diode Zener (ZD2), lesquels sont montés en série, dans lequel le circuit (14) relie un nœud (20) entre le condensateur (C3) et l'au moins une diode Zener (ZD2) à la deuxième borne (L') dans le premier état de commutation.

7. Compteur d'électricité selon la revendication 6, **caractérisé en ce que** le circuit (14) est configuré de telle façon qu'une chute de tension survenant dans le premier état de commutation lors d'un passage de courant par la liaison établie est inférieure à une chute de tension au niveau de l'au moins une diode Zener (ZD2) lors d'un fonctionnement dans le sens passant.

8. Compteur d'électricité selon l'une des revendications 1 à 7, **caractérisé en ce que** le circuit (14) établit la liaison par le biais d'un transistor (Q1) et d'une diode Schottky (D3).

9. Compteur d'électricité selon la revendication 8, **caractérisé en ce que** le transistor (Q1) est un transistor à effet de champ.

10. Compteur d'électricité selon l'une des revendications 1 à 9, **caractérisé en ce que** la commande électronique (38) est conçue pour actionner le circuit (14) par intervalles et/ou selon un schéma temporel prédéfini.

11. Compteur d'électricité selon l'une des revendications 1 à 10, **caractérisé en ce que** le circuit (14) présente une entrée de commande (26), laquelle est reliée à une sortie de la commande électronique (38).

12. Compteur d'électricité selon la revendication 11, **caractérisé en ce que** la commande électronique (38) présente une puce de mesure dotée d'une borne à interruption, laquelle est reliée à l'entrée de commande (26).

13. Compteur d'électricité selon l'une des revendications 1 à 12, **caractérisé en ce que** le compteur d'électricité présente un dispositif d'évaluation, lequel est conçu pour déterminer une différence entre une première consommation sur une première durée pendant laquelle l'alimentation électrique (40) a été approvisionnée en courant non compté, et une deuxième consommation sur une deuxième durée pendant laquelle l'alimentation électrique (40) a été approvisionnée en courant compté, et pour comparer celle-ci avec une consommation propre attendue du compteur d'électricité.

14. Compteur d'électricité selon l'une des revendications 1 à 13, **caractérisé en ce que** le compteur d'électricité présente un dispositif de communication, lequel est conçu pour envoyer une alerte de manipulation lorsque le dispositif d'évaluation constate un écart lors de la comparaison de la différence déterminée avec la consommation propre attendue.
